**Europäisches Patentamt**

(19) **European Patent Office**

**Office européen des brevets**

(11) Publication number: **0 252 115 B1**

(12) # EUROPEAN PATENT SPECIFICATION

(45) Date of publication of patent specification :
**17.07.91 Bulletin 91/29**

(51) Int. Cl.⁵ : **H01L 23/48, H01L 23/32**

(21) Application number : **87900397.8**

(22) Date of filing : **24.11.86**

(86) International application number :
**PCT/US86/02509**

(87) International publication number :
**WO 87/04009 02.07.87 Gazette 87/14**

(54) **COMPRESSIVE PEDESTAL FOR MICROMINIATURE CONNECTIONS.**

(30) Priority : **20.12.85 US 811560**

(43) Date of publication of application :
**13.01.88 Bulletin 88/02**

(45) Publication of the grant of the patent :
**17.07.91 Bulletin 91/29**

(84) Designated Contracting States :
**DE FR GB IT NL**

(56) References cited :
**EP-A- 0 032 068**
**FR-A- 2 288 394**
**US-A- 4 070 688**

(73) Proprietor : **Hughes Aircraft Company**
**7200 Hughes Terrace P.O. Box 45066**
**Los Angeles, California 90045-0066 (US)**

(72) Inventor : **PATRAW, Nils, E.**
**550A Avenue F**
**Redondo Beach, CA 90277 (US)**

(74) Representative : **Kuhnen, Wacker & Partner**
**Schneggstrasse 3-5 Postfach 1553**
**W-8050 Freising (DE)**

## Description

### BACKGROUND OF THE INVENTION

#### 1. Cross Reference to Related Patent Applications.

The present patent application is related to two patent applications entitled "Inverted Chip Carrier" published under WO 87/06062 and "Chip Interface Mesa" published under WO 87/04010 both also invented by Nils E. Patraw and both assigned to the Hughes Aircraft Company.

#### 2. Field of the Invention.

The present invention pertains to Ultra-Dense, Extremely Large Scale Integration and wafer scale synthesis of microelectronic components residing on a large number of integrated circuits. The specific focus of the preferred embodiment is the planar and orthogonal space optimization of active microelectronic circuit elements which makes possible multi-chip VHSIC hybrids having extraordinarily high signal processing capabilities and enormous memory capacity.

#### 3. Background Information.

Over the past four decades, the electronics industry has witnessed vast improvements in the performance of electronic components. The transition from thermo-ionic devices to solid state diodes and transistors was the first phase of intense efforts to miniaturize circuitry in order to construct powerful digital computers. The second great phase of innovation involved the consolidation of discrete solid state devices into a compact, unitary circuit which shared a single housing. Before the advent of integrated circuits, components like transistors were individually encapsulated in plastic cases or resided separately in metal cans. These single elements were generally mounted on circuit boards and each had a number of leads connected together by soldered wires. The first generation of integrated circuits combined many discrete active elements together on several alternating layers of metallic anti dielectric films which were deposited on an insulating substrate. These early integrated circuits, called thin-film hybrids, were the precursors of current integrated circuits which contain a solitary, but extremely powerful and densely packed, semiconductor chip or die. This semiconductor chip comprises a base or substrate of material, upon which many thin layers are formed that are, in turn, coupled together by tiny, metallic interconnects or vias which pass vertically through the several horizontal layers. A semiconductive material such as silicon, germanium, or gallium arsenide can be chemically altered in order to form carefully selected, minute regions having different electrical properties. These distinct regions are now fabricated with great precision, and each region may measure less than one millionth of an inch (1 inch = 2,54 cm). A few regions which exhibit different degrees of electrical conductivity can be grouped together in order to form a device that can help perform a mathematical calculation or store information. These groups of microscopically small regions or zones within one of the many layers of one monolithic chip are the modern analogs to the discretely packaged components which preceded them twenty and thirty years ago.

As each phase of electronic components produced improvements in calculation speed and memory capacity, the packaging of these components became more and more important. Technological advancements that solve problems concerning the fabrication or further miniaturization of semiconductor materials and devices simultaneously create a concomitant packaging problem. As circuit components shrink to increasingly smaller dimensions, the problem of accessing each component grows worse. When integrated circuits become so densely packed that a million of separate active devices occupy a space smaller than the diameter of the eraser on a common pencil, the difficulties involved in exchanging information in the form of electrical signals between that vast network of tiny circuit elements and the outside world become enormous.

Another level of complication is reached when designers attempt to connect many integrated circuits together in a unitary system. Semiconductor chips which are shorter than the width of the eraser at the end of the pencil and less than two one hundreths of and inch thich are manufacturer simultaneously by the hundreds on thin circular wafers of semiconductive material that are typically about four inches wide. Recent attempts to couple all the separate chips on the wafer gave rise to the term wafer scale integration. An electronic device which could incorporate tens, hundreds, or perhaps even thousands or millions of already immensely powerful separate chips, each comprising roughly a million active components, together on one wafer would constitute a tremendous technological leap forward in the electronics arts.

Among the most serious problems encountered in designing and manufacturing integrated circuits and multiple integrated circuit arrays are the deleterious consequences of using fine filaments of wire to connect the miniscule terminals or pads which are the access points to the outside world from the internal circuitry of the integrated circuit. These fragile, very light gauge connecting wires are typically one one-thousanth of an inch in diameter. One common technique for attaching these wires or leads to the conductive external terminals of the chip is thermocompression bonding. This process combines the application of heat and stress on an integrated circuit die. A very small edge-shaped probe or tool called a bonding wedge must be viewed through a microscope and guided over a wire which is to be bonded onto a conductive pad. The pad is usually located at the periphery of the semiconductor chip or die, which is placed on a heating device in order to soften the metallic material comprising the pad. A refinement of the bonding wedge is called a nailhead or ball bonder, in which the pressure bonding tool consists of a glass capillary tube that feeds the wire through its center to the pad. A flame melts the end of the wire that protrudes out of the open end of the capillary tube and forms a ball having a diameter about twice the thickness of the wire. The wire is then retracted in the tube and the ball is held snugly against the orifice while the tube is moved over the pad and impressed upon it with considerable force. The compression deforms the ball into a flattened thermocompression bond shaped like the head of a nail. The tube is then pulled back from the pad, and the flame is employed again to melt the wire which is now attached to a pad on the die. The wires and the contact pads are typically made of gold or aluminum.

Although thermocompression bonding has proven useful over many years of manufacturing, this method suffers from many shortcomings. Aside from the great expense incurred in either bonding wires and pads manually or with the aid of costly automated equipment, any mechanical connection like a pressure bond is susceptible to failure caused by a multitude of environmental factors. Since any fabrication process will be less than perfect, some wirebonds will be faulty after manufacturing. Even if only one percent of the connections are inadequate, the entire electronic system which includes the chip with the bad connection may be rendered completely inoperative as a consequence. Different rates of expansion and contraction of the connected materials due to changes in temperature will tend to destroy bonds over time. The ambient environment may contain compounds which will initiate chemical processes such as oxidation that may corrode and destroy metallic connections. The installation of subcomponents, handling, or vibration encountered during use may detach these wire bridges in time.

In addition to the nettlesome problems of keeping a wire bond intact over the life of an electronic device, this mode of connecting portions of one chip or an array of many chips is beset by problems even if all the bonds are perfectly made and are never broken. The vast number of wire bonds needed to connect large numbers of chips result in an enormous total length of conductive pathways in the system circuit. These conductors consume electrical power since they are resistive components. Increased ambient temperature caused by this thermal heating may impair the operation of the associated integrated circuits. The wires inject unwanted inductance and capacitance into otherwise precisely balanced circuits. Crosstalk between conductors may severely impair the performance of the entire system. Time delays inherent in the long pathways reduce computation capability.

Perhaps the worst problem is the enormous space which is wasted when wires are used to connect together portions of a chip or an array of many chips. Each span of wire that connects two points which reside substantially in the same plane requires a looped, generally parabolic length of bent wire. The amount by which the wire can be bent is limited by the fragility and susceptibility of the wire to fracture. In addition, the size of the wire bonding tool mandates a minimum spacing between contact points which receive thermocompression bonds. These loops of wire impose limits on the horizontal density of the chip deployment, since a minimum space for each loop must be provided between each adjacent chip. Conventional wire bonding techniques impose die interspacing contraints of no less than twice the thickness of the die. If the die is on the order of twenty mils of an inch (1 mil = 25,4 μm) in height, as much as fifty mils will be wasted in order to provide adequate separation for the making the wire bonds. The pads which receive the wire bonds also consume precious space on the die. Each pad must be large and sturdy enough to tolerate the great pressure transmitted by the wire bond tool. The wire bonds not only consume valuable horizontal surface area on the face of the die, but also take up space above the plane of the die. The looped portions of the connecting wires can extend far above the die face and preclude the stacking of several levels of chip array planes.

When connecting wires consume space above or below the active die surface, the vertical or orthogonal space that extends perpendicular to the active circuitry must be reserved for protruding wires. These exposed wires are vulnerable to a host of environmental hazards including physical shock, vibration, extremes of temperature and damage during the assembly process.

Previous microcircuit connection and wafer scale integration inventions have attempted to solve the deployment and packaging problems inherent in combining and connecting millions of active circuit components using a variety of approaches. In United States Patent Number 3,436,605, Landron describes a packaging process for semiconductor devices that includes conductive pathways deployed on a substrate which terminate in a plurality of spaced rounded pedestals which have bonding surfaces. Landron's pedestals may have hemispherical tips and can be arranged in a triangular pattern on a header which also holds individual transistors.

Wakely discloses modular packages for semiconductor devices in United States Patent Number 3,483,308. Wakely's design incorporates a rectangular body of insulating material having a flat upper surface which retains a semiconductor chip coupled to conductive pathways using looped wirebonds. The conductive pathways are also connected through the center of the rectangular body to downwardly depending pedestals. The pathways terminate at the ends of the pedestals where they are electrically coupled to a printed circuit board.

In United State Patent Number 4,179,802, Joshi et al. explain a studded chip attachment process. Metal studs are plated on a chip carrier surface to match a terminal metal footprint of a corresponding chip. Chips are attached to a carrier by joining metal pads on the chip to corresponding studs on a silicon substrate of the carrier. A very small amount of solder is used to complete the bond between the studs and the pads.

Robillard et al. disclose an integrated test and assembly device in United States Patent Number 4,189,825. This invention includes an integrated circuit device, a package frame having conductive leads that extend through an insulative portion of the package, and an interconnection substrate having apertures for receiving chips.

A method for employing precision stamping for fabricating wafers in a multi-wafer circuit structure is disclosed in United States Patent Number 3,813,773 by Parks. This invention employs a plurality of conductive wafers which are stacked together under pressure in order to form a parallelpiped structure containing integrated circuit chips. Parks uses a uniform rectangular matrix of z-axis slugs separated by dielectric material as terminals for connecting the integrated circuits to external devices.

In United States Patent Number 2,850,681, Horton discloses a subminiature structure for electrical apparatus which includes a combination of a plurality of wafers made of rigid insulating material, conductors fixed to each wafer, and connections between the electrical components on these wafers.

Vizzer describes a modular component printed circuit connector in United States Patent Number 3,107,319. This invention uses a modular component base block which is attached to printed circuit boards having end slots for the insertion of circuit connector elements that are retained by spring loaded terminals.

A flat package for semiconductors which includes an insulating ceramic substrate having a channel that receives a semiconductor wafer that is bonded to a gold surface is disclosed in United States Patent Number 3,271,507-Elliott.

In United States Patent Number 4,288,841, Gogal describes a semiconductor device including a double cavity chip carrier which comprises a multi-layer ceramic sandwich structure that has a pair of chip cavities. The inventor claims that this structure is useful for connecting two integrated circuits which have different terminal patterns.

Minetti reveals a method of forming circuit packages using solid solder to bond a substrate and contact members in United States Patent Number 4,332,341. Minetti's ceramic chip carrier includes a ceramic body with castellations formed at the edges of the carrier surfaces. Multi-layer contact members are coupled to contact pads which are, in turn, connected to leads from an integrated circuit chip.

Hall et al. explain a method of fabricating circuit packages which employ macro-components mounted on supporting substrates in United States Patent Number 4,352,449. In order to maintain sufficient clearance between components and the substrate and to achieve high reliability bonds, Hall employs massive solder preforms which are applied to contact pads on either the components or the substrate. This invention also involves the bonding of lead-tin solder spheres having a diameter of twenty to forty mils to contact pads on a chip carrier.

In Unifed States Patent Number 3,811,186, Larnerd et al. describe a method for aligning and supporting microcircuit devices on substrate conductors when the conductors are attached to the substrate. A shaped, flexible, insulative material placed between the devices and their corresponding conductors supports terminals which can be fused together with heat in order to attach conductors after they have been properly aligned.

Beavitt et al. disclose an integrated circuit package including a number of conductors bonded between a cover and a cavity formed within a base that holds a chip in United States Patent Number 3,825,801. This cavity serves as a carrier for the chip, which is held in place between conductive strips at resilient material that are secured between a base and cover of insulating material.

A process far producing sets at small ceramic devices much as leadless inverted chip carriers that have solderable external connections is disclosed by Hargis in United States Patent Number 3,864,810. After firing several layers of ceramic material on a base sheet, Hargis mounts a chip an the ceramic carrier by embedding or encapsulating it in an epoxy resin in order to provide leads for the chip which are more easily connected to external devices than the chip terminals themselves.

In United States Patent Number 3,868,724, Perrino reveals connecting structures for integrated circuit chips which are fabricated by forming many sets of leads on a flexible tape. These leads penetrate through holes formed in the tape and terminate in contacts which are arranged in a pattern that corresponds to a pattern of contacts on an integrated circuit chip. The chips are enclosed by an epoxy encapsulant after they are bonded to the contacts.

Hartleroad et al. explain a method and apparatus for positioning semiconductor flip chips onto one end of a transfer probe which automatically and magnetically aligns the chips and bonds them to an overlying lead frame structure. Their method for placing flip chips into one end of an elongated groove of a positioning apparatus and conveying them on guide rails using a magnetic force to properly locate the chips before bonding is the subject of United States Patent Number 3,937,386.

An electrical package for Large Scale Integrated devices which utilizes solder technology to interconnect a carrier, a circuit transposer and LSI devices is described by Honn et al. in United States Patent 4,074,342. The Honn electrical package includes a carrier which has a thermal expansion coefficient similar to semiconductive material, a standard array of terminal pins, and the transposer, which they claim eliminates mechanical stress on solder joints that is caused by dissimilar thermal expansion of the various packaging materials.

Inoue discloses a semiconductor device insulation method in United States Patent Number 4,143,456. This invention employs a protective covering for a semiconductor device which includes a circuit board bearing a conductive pattern and a chip. Inoue fixes his chip with a eutectic or electrically connected adhesive to a die bonded portion of the circuit board pattern with aluminum wire.

United States Patent Number 4,147,889-Andrews et al. describe a thin, dielectric, dish-shaped chip carrier which has flexible mounting flanges having plated or bonded solderable conductive traces and paths. These traces and paths are coupled with plated or bonded heat sinks which are electrically grounded and provide structural integrity.

A flat package for an integrated circuit device that has output pads comprising a supporting member for the integrated circuit device, external output terminals, and array of output conductors, and an electrically insulating encapsulation cover is illustrated in Ugon's United States Patent Number 4,264,917. This invention includes contact islands arranged on a supporting wafer to provide a package for one or more integrated circuit devices having a reduced thickness and surface area.

None of the inventions described above solves the problem of wasted planar and orthogonal space that results from the high portion of chip assemblies that are devoted to chip interconnections such as wirebonds. None of these prior methods or apparatus provides an effective and comprehensive solution which addresses all of the complex aspects of achieving ultra-high density of active semiconductor components. Such a solution to this problem would satisfy a long felt need experience by the semiconductor and integrated circuit industries for over three decades.

A truly practical and reliable means for producing efficacious intra-chip and chip-to-chip interconnections without squandering a substantial portion of the die's planar and orthogonal space would constitute a major advancement in the microelectronics field. Manufacturers of semiconductor dies could employ such an innovative design to produce integrated circuits capable of processing information at speeds greatly exceeding the current state of the art and and capable of storing vast quantities of data far beyond today's most densely packed designs. Such an invention would ideally be suited to operate in cooperation with a wide variety of computing systems and would perform consistently and reliably over a wide range of operating conditions and system applications. Extremely Large Scale Integration microcircuitry would also satisfy the rigorous demands of supercomputers and orbital defense systems. An invention which enables aerospace microelectronic designers to deploy enormously powerful yet extremely compact integrated circuits in orbit for space defense systems would most certainly constitute a major technological advancement in the electronics arts.

## SUMMARY OF THE INVENTION

The aim of the present invention is to help accomplish thin major technological advancement. The Patraw Compressive Pedestal for Microminiature Connections enables designers of integrated circuits to connect the integrated circuits together in order to form unitary, on-wafer chip arrays which have signal processing and memory capacities that dwarf previous previous discretely connected, multiple integrated circuit systems. The present invention extends the current state of the art beyond Very Large Scale Integration (VLSI) capabilities to the higher range of Ultra-Dense, Extremely Large Scale Integration (ELSI) using the wafer scale synthesis techniques described and claimed below.

The present invention is, in its best mode of implementation, designed to be used with the Chip Interface Mesa, which was also invented by Nils E. Patraw and is described in the patent application WO 87/04010 having that title which is also commonly assigned to the Hughes Aircraft Company. The chip interface mesa is fabricated from an dielectric material and has a generally rectangular shape having dimensions that are generally slightly smaller than the semiconductor die upon which it resides. The mesa has a rectangular cross-section and may be epoxied to the top of the die which bears the uppermost level of active circuitry. The perimeter of the mesa is populated by vertical channels or notches which are coated with a layer of conductive material. The top face of the mesa contains an array of conductive regions or external interface pads which are much larger than conventional bond pads. These external interface pads are electrically coupled to a notch on the side wall of the mesa by a thin conductive pathway. Each notch in the mesa in aligned with a conductive chip interface pad on the semiconductor chip. The chip interface pads are deployed on the periphery of the top surface of the chip which is bonded to the mesa. A drop of heated solder or other easily deformable conductive material is placed in each notch from above the mesa and forms an electrical link between the mesa and a chip interface pad, since the solder joins with both the pad and the vertical walls of the notch.

This microelectronic packaging configuration constitutes an important improvement and refinement of the Patraw Inverted Chip Carrier, which substantially eliminates long looped wirebonds by redirecting intra-chip and chip-to-chip interconnections to orthogonal space over the active circuitry of the chip. The Chip Interface Mesa eliminates wirebonds completely. All undesirable wire couplers are supplanted by durable and easily formed solder droplet connections inside a notch which is in registry with a corresponding chip pad. The repositioning of intra-chip and chip-to-chip interconnections into space over the active circuitry optimizes packaging space for integrated circuit assemblies and enables designers to approach the theoretical density limit for semiconductor devices due to the enormous saving of space which was once wasted by wirebonds between adjacent chips. The Chip Interface Mesa reserves nearly all of the planar space of a multi-chip array for active semiconductor circuitry, and banishes inefficient interconnection space to a volume over or orthogonal to the plane of the active circuitry. That important new integrated circuit assembly design not only optimizes packaging criteria, but also permits the stacking of many parallel levels of contiguous chips with a minimum of costly inter-chip spacing. By connecting many chips together, many semiconductor dies on a wafer can be combined in order to realize full, water-scale reconstruction.

The present invention is yet another evolution of the innovative concepts disclosed and claimed in the above mentioned patent applications entitled "Inverted Chip Carrier" and "Chip Interface Mesa." The Compressive Pedestal for Microminiature Connections is a body of conductive material having a upper portion and at least three legs which extend from the upper portion. The legs terminate in flared contact pads which are capable of securely mating to a substantially flat conductive pad in order to form a reliable electrical coupling. These legs are designed to mate to one of the mesa interface pads on the Chip Interface Mesa. The pedestal is formed from a metal which is flexible and will provide an oppositely directed spring tension when the entire pedestal is subjected to a loading force that presses it against a mesa interface pad. By using a compressive pedestal with a chip interface mesa and chip assembly as described and claimed in the related patent application, a greatly improved packaging array for integrated circuits which enables virtual wafer scale reconstitution leading to system densities that exceed current VLSI technology is made possible. The compressive pedestal may be used to fabricate chip interface mesa arrays that combine hundreds or thousands of interconnected chip interface mesa and chip assemblies. Single chip carriers may be constructed using the present invention in a spring-loaded receptacle which provides easy access and replacement of the chip.

It is, therefore, an object of the present invention to provide a simple, reliable means of connecting large arrays of interconnected integrated circuit assemblies using a device which is easily and cost-effectively mass produced.

It is an object of this invention to provide a microelectronic interconnection device which does not destroy its corresponding chip or carrier when the subcomponents of an integrated circuit assembly such as a chip interface mesa and chip assembly are separated so that chips may be repeatedly tested, probed, or replaced without destroying the means which incorporates it into a large, complex system of integrated circuits.

A further object of the present invention is to provide an integrated circuit packaging solution which does not adversely affect the yield of expensive chips during the chip manufacturing process.

It is an object of the present invention to provide an apparatus for microelectronic interconnection which completely eliminates undesirable and unreliable wirebonds.

Another object of the present invention is to provide apparatus for micro-miniature electronic interconnection which maximizes the density of active, integrated circuit devices in a given volume.

Another object of this invention is to provide a simple and reliable means of connecting circuits within a chip or connecting circuits within many different chips in order to make previously impossible wafer-scale synthesis designs practical and cost-effective.

Still another object of the present invention is to provide a means of connecting large numbers of semiconductor dies using currently commercially available dies and existing packaging technology.

Yet another object of the invention is to provide chip arrays having increased system speeds due to drastic reductions in propagation delay times which results from the total elimination of interconnecting wires.

It is also an object of this invention to provide a chip carrier which enables designers to take advantage of enormous reductions in power consumption, since the elimination of a multitude of long wirebonds dispenses with a primary source of wasteful, capacitive loading.

Another object of the present invention is to provide a method of installing many chips together on a chip carrier which may be easily tested, inspected, burned-in, and repaired.

Still another object of this invention is to provide a chip deployment scheme which minimizes chip-to-chip input/output requirements.

Yet another object of the invention claimed below is to provide apparatus for microelectronic interconnection which avoids the deleterious additional capacitance and inductance that are introduced by prior devices which incorporate many long wire connectors within integrated circuit assemblies.

It is also an object of the present invention to cut down the mass of integrated circuit systems in order to fabricate systems which can be economically placed in an orbital environment.

An appreciation of other aims and objects of the present invention and a more complete and comprehensive understanding of the this invention may be achieved by studying the following description of a preferred embodiment and by referring to the accompanying drawings.

BRIEF DESCRIPTION OF THE DRAWINGS

FIGS. 1a through 1e illustrate a preferred method of fabrication of the present invention by showing the various stages of formation of the compressive pedestal on a substrate. FIG. 1f is a perspective view of two completed compressive pedestals on a substrate that are connected by conductive pathways.

FIG. 2 is a perspective view of a multi-chip array of chip and chip interface mesa assemblies retained in and linked by corresponding receptacles by compressive pedestals which are, in turn, linked to an interconnection device.

FIG. 3 is side cross-sectional view of a single chip carrier using compressive pedestals to retain and link a chip.

DESCRIPTION OF A PREFERRED EMBODIMENT

The chip and chip interface mesa assembly which may be employed in combination with the compressive pedestal is fully described in detail in said patent application entitled "Chip Interface Mesa" by Nils E. Patraw. The description of that invention, including the drawings figures contained in that patent application, are hereby incorporated into the present patent application by reference.

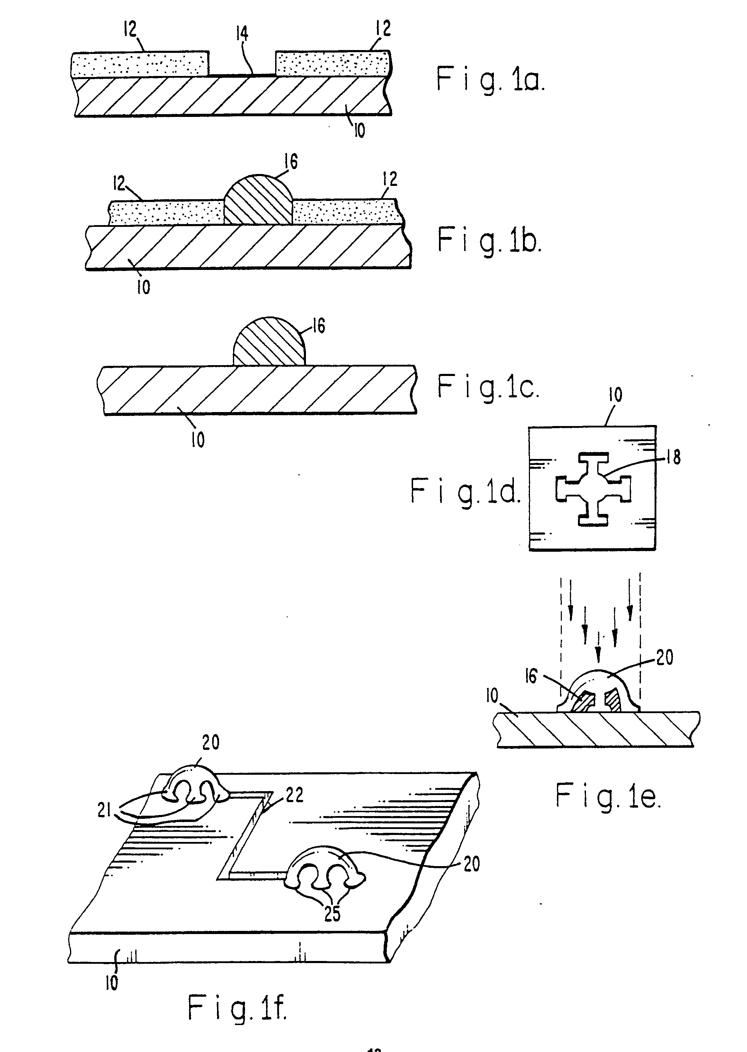

FIGS. 1a through 1e depict the sequence of operations employed to fabricate the preferred embodiment of the compressive pedestal. A substrate 10 is covered or screened with wax, photoresist, thermoplastic, or metal substrate mask 12 which has a pattern of circular holes 14 that are approximately 4 to 12 mils across. The holes 14 are filled with a material such as potassium chloride or photoresist to a level at which a positive meniscus is formed (FIG. 1b). A rounded pillar 16 is formed within each hole 14. The substrate mask 12 is removed with a suitable dissolving substance which leaves only the pillar 16 on the substrate 10 (FIG. 1c). In FIGS. 1d and 1e, a metal mask 18 having a central body portion and four radially extending members is placed over pillar 16 in order to deposit a layer of aluminum over the pillar 16. FIG. 1f reveals two finished compressve pedestals 20 having four downwardly depending legs 21 that terminate in flared, generally flattened pads 25. The pedestals 20 sit atop a substrate 10 and are connected by a conductive pathway 22. The pedestals 20 are designed to be deployed upon the mesa interface pads shown in the related patent application entitled "Chip Interface Mesa". In order to form a reliable bond between the pedestal and the conductive surface which receives it, the pedestals are coated with an indium alloy in an environment heated to approximately 150 degrees Centigrade.

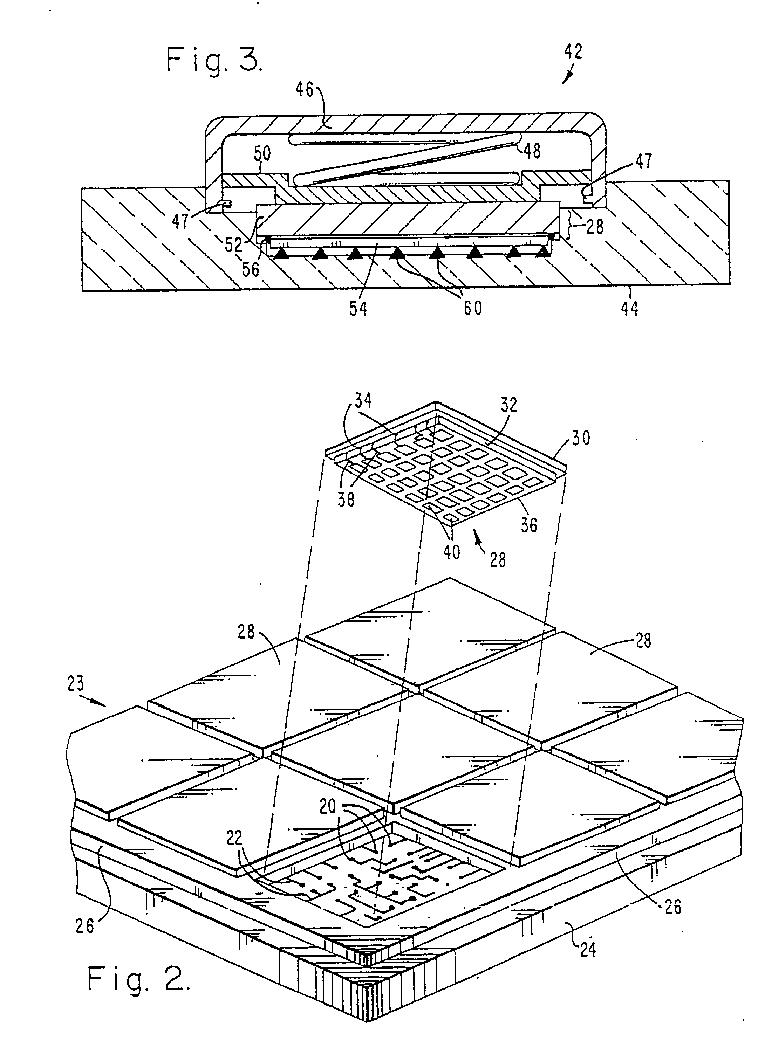

FIG. 2 illustrates a multi-chip array which includes many chip interface mesa and chip assemblies 28 in a matrix like arrangement. Each assembly 28 is retained in a receptacle containing a plurality of corresponding compressive pedestals 20 which are connected to conductive pathways 22 that are, in turn, electrically coupled to external terminals (not shown) associated with interconnection substrate 24. The receptacles are arranged on substrate 24 atop an alignment spacer 26. Each assembly 28 comprises a chip 30, a mesa member 32, notches 34 bearing connective solder droplets (not shown in this drawing), and a matrix of oversized mesa interface pads 40 deployed atop a planar mesa surface 36 of their corresponding mesa member 32. The pads 40 are connected to their respective chip 30 via conductive pathways 38 and are electrically coupled to the multi-chip array 23 via the compressive pedestals 20.

FIG. 3 depicts a single chip carrier 42 using compressive pedestral. A ceramic body 44 contains a receptacle which holds a chip interface mesa and chip assembly 28. A removable cover 46 secured by a retaining ring 47 holds a conventional spring 48 in place over a piston 50. The piston 50 provides a continuous pressure which holds assembly 28, including chip 52, mesa member 54, and solder droplets 56, against terminals 60 at the bottom of the receptacle. The terminals 60 are connected to internal connectors (not shown) within the ceramic body 44 which are, in turn, linked to external terminals or edge contacts (not shown) at the periphery of ceramic body 44.

The Patraw Inverted Chip Carrier, which is described in detail in related patent application WO 87/06062, enables a designer ordinarily skilled in the art to take a current, commercially available chip, place that chip in this new carrier, and realize an enormous increase in volume available for active circuitry of 65% for only a tiny 3% increase in planar area compared to the bare die dimensions. The Patraw Chip Interface Mesa provides even greater volume to surface area ratios by completely eliminating all wirebonds. Nearly all the inter-chip spacing required in conventional manufacturing techniques is avoided by employing solder droplets in mesa receptacles that extend perpendicular to the plane of the chip's active circuitry to form the electrical interconnections between the chip and the outside world. The Patraw Compressive Pedestal for Microminiature Connections combines the advantages of the previous two inventions with another great benefit of designing large multi-chip arrays in which the component chips are packaging in an ultra-dense configuration and are easily replaced or removed.

## Claims

1. A method for making a resilient microelectronic connective member including the steps of :
providing a substrate (10) for forming said resilient microelectronic connective member (20) ;
covering said substrate (10) with a substrate mask (12) having an aperture (14) ;
filling said aperture (14) with a filling material which will form a positive meniscus at the top boundary of said substrate mask (12) in order to form a rounded pillar (16) on said substrate (10) within said aperture (14) ;
dissolving said substrate mask (12) with a dissolving substance that will remove said substrate mask (12) from said substrate (10) but that will leave said pillar (16) intact on said substrate (10) ;
placing a pedestal design mask (18) over said pillar (16) leaving portions of said pillar (16) exposed ;
depositing a layer of metal over said pedestal design mask (18) in order to form a resilient microelectronic connective member (20) on the exposed portions of said pillar (16) ; and
dissolving said pillar (16) with a dissolving substance that will remove said pillar (16) but that will leave said resilient microelectronic connective member (20) on said substrate (10).

2. A method for fabricating a compressive pedestal (20) for microminiature connections including the steps of :
providing a multi-layer, dielectric substrate (10) for forming said compressive pedestal (20) for microminiature connection ;
covering said substrate (10) with a photoresist substrate mask (12) having a cylindrical hole ;
depositing potassium chloride in said hole in order to form a pillar (16) having a generally rounded top portion on said substrate within said cylindrical hole ;
dissolving said photoresist substrate mask (12) with a dissolving substance that will remove said photoresist substrate mask (12) from said substrate (10) but that will leave said pillar (16) intact on said substrate (10);

placing a pedestal design mask (18) over said pillar leaving portions of said pillar (16) exposed ;
depositing a layer of aluminum over said pedestal design mask (18) in order to form a compressive pedestal (20) for microminiature connection on the exposed portions of said pillar (16) ; and
dissolving said pillar (16) with a dissolving substance that will remove said pillar (16) but that will leave said compressive pedestal (20) for microminiature connection on said substrate (10).

3. A compressive pedestal (20) for microminiature connections comprising :
a metal die having an essentially hemispherical contour including a central portion and at least three radiating electrical connector legs (21), each of said legs (21) terminating in a flared and flattened pad (25) suitable for making a secure electrical junction with a substantially flat conductive surface ; and
said die being fabricated from a metal which enables said die to flex like a spring under a pressure imposed upon said central portion.

4. A combination for providing a chip interface mesa and a plurality of compressive pedestals (20) for microminiature connections comprising :
a mesa member 32 made from a dielectric material having :
a first planar axis extending parallel to the longest planar dimension of said mesa member (32), a second planar axis extending parallel to the second longest planar dimension of said mesa member (32),
a transverse axis extending perpendicular to both said first and second planar axes,
a top planar mesa surface extending substantially perpendicular to said transverse axis and bounded by said longest and said shortest planar dimensions of said mesa member (32),
a plurality of planar perimeter walls disposed generally parallel to said transverse axis,
a plurality of vertical electrical coupler means located substantially near said planar perimeter walls,
said plurality of vertical electrical coupler means each having a vertical dimension which is substantially parallel to said transverse axis of said mesa member (32),
said plurality of vertical electrical coupler means each further having a conductive coating extending along said vertical dimension of said coupler means,
a plurality of mesa interface conductive terminals (40) disposed upon said top planar mesa surface,
said plurality of mesa interface conductive terminals (40) disposed upon said top planar mesa surface being electrically coupled to a plurality of conductive pathways (38) which are mechanically coupled to said top planar mesa surface,
said plurality of conductive pathways (38) being further selectively and electrically coupled to said vertical electrical coupler means,

a semiconductor chip (30) having two planar dimensions corresponding to said chip's two longest dimensions of length and width ;

said semiconductor chip (30) further having a top chip surface bounded by said two planar dimensions which contains an uppermost layer of active circuitry ;

said chip (30) further having a plurality of chip interface means deployed upon said top chip surface and generally surrounding said uppermost layer of active circuitry ;

said plurality of chip interface means also being selectively connected to said active circuitry and disposed generally at the periphery of said top chip surface ;

said semiconductor chip (30) being mechanically coupled to said mesa member (32) so that said top chip surface is substantially adjacent to said mesa member (32),

said plurality of chip interface means also being selectively and electrically coupled to said vertical electrical coupler means by a plurality of mesa-chip electrical contact means ; and

a plurality of compressive pedestals (20) for microminiature connection as claimed in Claim 3 deployed on said mesa interface conductive terminals ; said compressive pedestals (20) being adapted to receive a plurality of external connectors bearing on said compressive pedestals (20) in a spring-loaded arrangement.

5. A combination for providing a chip interface mesa and a plurality of compressive pedestals (20) for microminiature connections in a single chip carrier (42) comprising :

a ceramic body (44) having a recess adapted to receive and retain a combination (28) for providing a chip interface mesa and a plurality of compressive pedestals (20) for microminiature connections as claimed in Claim 4 ;

a piston (50) disposed adjacent to said combination (28) for providing a chip interface mesa and a plurality of compressive pedestals (20) for microminiature connections ;

said piston (50) being further urged into mechnical engagement with said combination (28) for providing a chip interface mesa and a plurality of compressive pedestals (20) for microminiature connections by a spring (48) ; and

said spring (48) being retained in compression against said piston (50) by a removeable cover (46) adapted to fit securely in said ceramic body (44).

## Patentansprüche

1. Verfahren zur Herstellung eines elastischen, mikroelektronischen Verbindungsteils (20), das folgende Schritte beinhaltet :

Bereitstellung eines Substrats (10) zur Ausbildung des elastischen, mikroelektronischen Verbindungsteils (20) ;

Bedecken des Substrats (10) mit einer Substratmaske (12), die eine Öffnung (14) aufweist ;

Befüllen der Öffnung (14) mit einem Füllmaterial, das einen positiven Meniskus auf der Obergrenze der Substratmaske (12) ausbildet, um eine abgerundete Säule (16) auf dem Substrat (10) innerhalb der Öffnung (14) zu bilden ;

Auflösen der Substratmaske (12) mit einem Lösemittel, das die Substratmaske (12) vom Substrat (10) entfernt, aber die Säule (16) auf dem Substrat (10) intakt läßt ;

Überstülpen der Säule (16) mit einer Maske (18) zur Sockelausbildung, wobei Teile der Säule (16) exponiert bleiben ;

Niederschlagen einer Metallschicht auf die Maske (18) zur Sockelausbildung, um ein elastisches, mikroelektronisches Verbindungsteil (20) auf den exponierten Teilen der Säule (16) zu bilden ; und

Auflösen der Säule (16) mit einem Lösemittel, das die Säule (16) entfernt, aber das elastische, mikroelektronische Verbindungsteil (20) auf dem Substrat (10) zurückläßt.

2. Verfahren zur Herstellung eines zusammenpressenden Sockels (20) für Mikro-Verbindungen, das folgende Schritte beinhaltet :

Bereitstellen eines vielschichtigen, dielektrischen Substrates (10) zur Ausbildung des zusammenpressenden Sockels (20) für Mikro-Verbindungen ;

Bedecken des Substrates (10) mit einer lichtunempfindlichen Substratmaske (12), die ein zylindrisches Loch aufweist ;

Niederschlagen von Kaliumchlorid in das Loch, um eine Säule (16) zu bilden, die einen im großen und ganzen abgerundeten oberen Teil auf dem Substrat (10) innerhalb des zylindrischen Loches aufweist ;

Auflösen der lichtunempfindlichen Substratmaske (12) mit einem Lösemittel, das die lichtunempfindliche Substratmaske (12) vom Substrat (10) entfernt, aber die Säule (16) auf dem Substrat (10) intakt läßt ;

Überstülpen der Säule mit einer Maske (18) zur Sockelausbildung, die Teile der Säule (16) exponiert läßt ;

Niederschlagen einer Aluminiumschicht auf die Maske (18) zur Sockelausbildung, um einen zusammenpressenden Sockel (20) für Mikro-Verbindungenauf den exponierten Teilen der Säule (16) auszubilden ; und

Auflösen der Säule (16) mit einem Lösemittel, das die Säule (16) entfernt, aber den zusammenpressenden Sockel (20) für Mikro-Verbindungenauf dem Substrat (10) zurückläßt.

3. Ein zusammenpressender Sockel (20) für Mikro-Verbindungen, enthaltend :

eine metallische Druckplatte, die eine im wesentlichen halbkugelige Form aufweist, die ein Zentralteil und wenigstens drei strahlenförmig angeordnete Verknüpfungsbeine (21) beinhaltet, wobei jedes der Beine (21) in einem konisch erweiterten und abgeflachten Wulst (25) endet, die sich für die Herstellung einer sicheren elektrischen Verbindung mit einer im wesentlichen ebenen, leitfähigen Oberfläche eignet ; wobei die Druckplatte aus einem Metall hergestellt ist, das die Druckplatte unter einem auf das Zentralteil ausgeübten Druck so elastisch wie eine Sprungfeder macht.

4. Eine Kombination zur Bereitstellung eines Mesa-Chip-Interface und einer Vielzahl von zusammenpressenden Sockeln (20) für Mikro-Verbindungen, beinhaltend :

ein Mesa-Teil (32), das aus einem dielektrischen Material hergestellt ist und aufweist :

eine erste planare Achse, die parallel zur längsten planaren Dimension des Mesa-Teiles (32) verläuft,

eine zweite planare Achse, die parallel zur zweitlängsten planaren Dimension des Mesa-Teiles (32) verläuft,

eine diagonale Achse, die sowohl zur ersten als auch zur zweiten planaren Achse im rechten Winkel verläuft,

eine obere planare Mesa-Oberfläche, die im wesentlichen senkrecht zur diagonalen Achse verläuft und von der längsten und der kürzesten planaren Dimension des Mesa-Teils (32) begrenzt ist,

eine Vielzahl von planaren Perimeterwänden, die im großen und ganzen parallel zur diagonalen Achse angeordnet sind,

eine Vielzahl von vertikalen elektrischen Kopplungsmitteln, die im wesentlichen in der Nähe der planaren Perimeterwände angeordnet sind,

wobei die vielen vertikalen elektrischen Kopplungsmittel alle eine vertikale Dimension aufweisen, die im wesentlichen parallel zur diagonalen Achse des Mesa-Teils (32) ist, und

wobei die vielen vertikalen elektrischen Kopplungsmittel desweiteren alle eine leitfähige Deckschicht aufweisen, die entlang der vertikalen Dimension der Kopplungsmittel verläuft,

eine Vielzahl an leitfähigen Anschlußflächen (40) des Mesa-Interface, die auf der oberen planaren Mesa-Oberfläche angeordnet sind,

wobei die vielen leitfähigen Anschlußflächen (40) des Mesa-Interface, die auf der oberen planaren Mesa-Oberfläche angeordnet sind, elektrisch mit einer Vielzahl leitfähiger Bahnen (38) verbunden sind, die mechanisch mit der oberen planaren Mesa-Oberfläche verbunden sind, und

wobei die vielen leitfähigen Bahnen (38) desweiteren trennscharf und elektrisch mit den vertikalen elektrischen Kopplungsmitteln verbunden sind,

einen Halbleiterchip (30), der zwei planare Dimensionen aufweist, die den zwei längsten Dimensionen bezüglich Länge und Breite des Chips entsprechen ;

wobei der Halbleiterchip (30) desweiteren eine obere Chip-Oberfläche aufweist, die von den beiden planaren Dimensionen begrenzt ist und eine oberste Schicht aus einer aktiven Schaltungsanordnung enthält ;

wobei der Chip (30) desweiteren eine Vielzahl an Chip-Interfacemitteln aufweist, die auf der oberen Chip-Oberfläche angeordnet sind und im großen und ganzen die oberste Schicht aus der aktiven Schaltungsanordung umgeben ;

wobei die vielen Chip-Interfacemittel ebenso trennscharf mit der aktiven Schaltungsanordnung verbunden sind und im großen und ganzen am Rand der oberen Chip-Oberfläche angeordnet sind ;

wobei der Halbleiterchip (30) mechanisch mit dem Mesa-Teil (32) verbunden ist, so daß die obere Chip-Oberfläche im wesentlichen an das Mesa-Teil (32) grenzt ; und

wobei die vielen Chip-Interfacemittel ebenso trennscharf und elektrisch mit den vertikalen elektrischen Kopplungsmitteln über eine Vielzahl an Mesa-Chip-Elektrokontaktmitteln verbunden sind ; und

eine Vielzahl an zusammenpressenden Sockeln (20) für Mikro-Verbindungen gemäß Anspruch 3, die auf den leitfähigen Anschlußflächen (40) des Mesa-Interface angeordnet sind ;

wobei die zusammenpressenden Sockel (20) so eingepaßt sind, daß sie eine Vielzahl an externen Anschlüssen aufnehmen, die auf den zusammenpressenden Sockeln (20) gefedert angeordnet sind.

5. Eine Kombination zur Bereitstellung eines Mesa-Chip-Interface und einer Vielzahl an zusammenpressenden Sockeln (20) für Mikro-Verbindungen in einem einzelnen Chipträger (42), beinhaltend :

einen keramischen Körper (44), der eine Aushöhlung aufweist, die so angepaßt ist, daß sie eine Kombination (28) zur Bereitstellung eines Mesa-Chip-Interface und einer Vielzahl an zusammenpressenden Sockeln (20) für Mikro-Verbindungen gemäß Anspruch 4 aufnimmt und zurückhält ; und

einen Stempel (50), der an die Kombination (28) zur Bereitstellung eines Mesa-Chip-Interface und einer Vielzahl an zusammenpressenden Sockeln (20) für Mikro-Verbindungen grenzt ;

wobei der Stempel (50) desweiteren über eine Feder (48) zur mechanischen Wechselwirkung mit der Kombination (28) zur Bereitstellung eines Mesa-Chip-Interface und einer Vielzahl von zusammenpressenden Sockeln (20) für Mikro-Verbindungen gezwungen ist ; und

wobei die Feder (48) den Druck auf den Stempel (50) über eine entfernbare Abdeckung (46) beibehält, die so eingepaßt ist, daß sie sicher in den keramischen Körper (44) paßt.

## Revendications

1. Procédé pour réaliser un élément de connexion microélectronique élastique, comprenant les étapes suivantes :

on prévoit un substrat (10) pour former l'élément de connexion microélectronique élastique (20) ;

on recouvre le substrat (10) d'un masque de substrat (12) comportant une ouverture (14) ;

on remplit l'ouverture (14) d'une matière de remplissage qui forme un ménisque positif à la limite supérieure du masque de substrat (12) de façon à former un pilier arrondi (16) sur le substrat (10) dans l'ouverture (14) ;

on dissout le masque de substrat (12) avec une substance dissolvante qui enlève le masque de substrat (12) du substrat (10) mais qui laisse le pilier (16) intact sur le substrat (10) ;

on place un masque à dessin de socle (18) sur le pilier (16) en laissant exposées des parties du pilier (16) ;

on dépose une couche de métal sur le masque à dessin de socle (18) de façon à former un élément de connexion microélectronique élastique (20) sur les parties exposées du pilier (16) ; et

on dissout le pilier (16) avec une substance dissolvante qui enlève le pilier (16) mais qui laisse l'élément de connexion microélectronique élastique (20) sur le substrat (10).

2. Procédé pour fabriquer un socle compressible (20) pour connexions microminiaturisées, comprenant les étapes suivantes :

on prévoit un substrat diélectrique multi-couche (10) pour former le socle compressible (20) pour connexions microminiaturisées ;

on recouvre le substrat (10) d'un masque de substrat en photorésist (12) comportant un trou cylindrique ;

on dépose du chlorure de potassium dans ledit trou de façon à former un pilier (16) ayant une partie supérieure globalement arrondie sur le substrat dans le trou cylindrique ;

on dissout le masque de substrat en photorésist (12) avec une substance dissolvante qui enlève le masque de substrat en photorésist (12) du substrat (10) mais qui laisse le pilier (16) intact sur le substrat (10) ;

on place un masque à dessin de socle (18) sur le pilier en laissant exposées des parties du pilier (16) ;

on dépose une couche d'aluminium sur le masque à dessin de socle (18) de façon à former un socle compressible (20) pour connexions microminiaturisées sur les parties exposées du pilier (16) ; et

on dissout le pilier (16) avec une substance dissolvante qui enlève le pilier (16) mais qui laisse le socle compressible (20) pour connexions microminiaturisées sur le substrat (10).

3. Socle compressible (20) pour connexions microminiaturisées, comprenant :

une matrice métallique à contour essentiellement hémisphérique comportant une partie centrale et au moins trois branches formant connecteur électrique s'étendant radialement (21), chacune des branches (21) se terminant en un plot élargi et aplati (25) convenant pour réaliser une jonction électrique sûre avec une surface conductrice sensiblement plane ; et

la matrice étant fabriquée à partir d'un métal qui permet à la matrice de fléchir sous l'effet d'une pression appliquée sur la partie centrale.

4. Combinaison pour obtenir un mesa d'interface de puce et plusieurs socles compressibles (20) pour connexions microminiaturisées, comprenant :

un élément en mesa (32) réalisé à partir d'un matériau diélectrique, comportant :

un premier axe de plan s'étendant parallèlement à la plus grande dimension plane de l'élément en mesa (32),

un deuxième axe de plan s'étendant parallèlement à la deuxième plus grande dimension plane de l'élément en mesa (32),

un axe transversal s'étendant perpendiculairement au premier et au second axe de plan,

une surface supérieure plane de mesa s'étendant de façon sensiblement perpendiculaire à l'axe transversal et délimitée par la plus grande et la plus petite dimension plane de l'élément en mesa (32),

plusieurs parois de bordure de plan disposées de façon globalement parallèle à l'axe transversal,

plusieurs moyens de liaison électrique verticale situés sensiblement auprès des parois de bordure de plan, chaque moyen de liaison électrique verticale ayant une dimension verticale qui est sensiblement parallèle à l'axe transversal de l'élément en mesa (32),

chaque moyen de liaison électrique verticale comportant en outre un revêtement conducteur s'étendant suivant ladite dimension verticale des moyens de liaison,

plusieurs bornes conductrices d'interface de mesa (40) disposées sur la surface supérieure plane de mesa,

les bornes conductrices d'interface de mesa (40) disposées sur la surface supérieure plane de mesa étant reliées électriquement à plusieurs trajets conducteurs (38) qui sont reliés mécaniquement à la surface supérieure plane de mesa,

les trajets conducteurs (38) étant en outre reliés sélectivement et électriquement aux moyens de liaison électrique verticale,

une puce semiconductrice (30) ayant deux dimensions planes correspondant aux deux plus grandes dimensions de la puce en longueur et en largeur ;

la puce semiconductrice (30) comportant en outre une surface supérieure de puce délimitée par les deux dimensions planes précitées qui comprend une couche supérieure de circuiterie active ;

la puce semiconductrice (30) comportant en outre plusieurs moyens d'interface de puce disposés sur la surface supérieure de puce et entourant globalement la couche supérieure de circuiterie active ;

les moyens d'interface de puce étant également connectés sélectivement à la circuiterie active et disposés globalement à la périphérie de la surface supérieure de puce ;

la puce semiconductrice (30) étant reliée mécaniquement à l'élément en mesa (32) de sorte que la surface supérieure de puce est sensiblement adjacente à l'élément en mesa (32) ;

les moyens d'interface de puce étant également reliés sélectivement et électriquement aux moyens de liaison électrique verticale par plusieurs moyens de contact électrique mesa-puce ; et

plusieurs socles compressibles (20) pour connexions microminiaturisées conformes à la revendication 3 disposés sur les bornes conductrices d'interface de mesa ; les socles compressibles (20) étant adaptés pour recevoir plusieurs connecteurs externes reposant sur les socles compressibles (20) dans un agencement mis en tension par un ressort.

5. Combinaison pour obtenir un mesa d'interface de puce et plusieurs socles compressibles (20) pour connexions microminiaturisées dans un support de puce unique (42), comprenant :

un corps en céramique (44) comportant un logement adapté pour recevoir et maintenir une combinaison (28) pour obtenir un mesa d'interface de puce et plusieurs socles compressibles (20) pour connexions microminiaturisées conforme à la revendication 4 ;

un piston (50) disposé adjacent à ladite combinaison (28) pour obtenir un mesa d'interface de puce et plusieurs socles compressibles (20) pour connexions microminiaturisées ;

le piston (50) étant en outre appliqué en appui mécanique sur ladite combinaison (28) pour obtenir un mesa d'interface de puce et plusieurs socles compressibles (20) pour connexions microminiaturisées au moyen d'un ressort (48) ; et

le ressort (48) étant maintenu en compression contre le piston (50) par un couvercle amovible (46) adapté pour se fixer fermement dans le corps en céramique (44).

Fig.1a.

Fig.1b.

Fig.1c.

Fig.1d.

Fig.1e.

Fig.1f.

Fig. 3.

Fig. 2.